# EUROPÄISCHE PATENTSCHRIFT

(11) **EP 2 103 827 B1**
(45) Veröffentlichungstag und Bekanntmachung des Hinweises auf die Patenterteilung: **04.09.2013**
(21) Anmeldenummer: 08005316.8
(22) Anmeldetag: 20.03.2008
(51) Int. Cl.: F16D 1/072

(54) **Welle-Nabe-Verbindung**
Shaft-to-collar connection
Liaison arbre-moyeu

(43) Veröffentlichungstag der Anmeldung: 23.09.2009
(73) Patentinhaber: Iprotec Maschinen- und Edelstahlprodukte GmbH, 32469 Petershagen-Friedewalde (DE)
(72) Erfinder: Kochsiek, Guido, 33818 Leopoldshöhe (DE)
(74) Vertreter: Stenger, Watzke & Ring

(56) Entgegenhaltungen:
- EP-A- 1 693 587
- DE-A1- 10 234 613
- US-A- 5 632 684
- US-A1- 2002 168 222
- US-A1- 2002 197 104
- US-A1- 2002 198 075

## Beschreibung

Die Erfindung betrifft eine Welle-Nabe-Verbindung mit einem von einer Welle bereitgestellten Nabensitz und einer vom Nabensitz aufgenommenen Nabe eines Bauteils, wobei der Nabensitz und die Nabe des Bauteils eine Unrund-Verbindung ausbilden.

"Unrund-Verbindung" im Sinne der vorliegenden Anmeldung umfasst alle Welle-Nabe-Verbindungen, die nicht kreisrund sind, also Ellipsen, Polygone, Verzahnungen, asymmetrische Mehrkants und dergleichen. Als Arbeitsbezeichnung wird im folgenden immer von der sogenannten "Polygon-Verbindung" gesprochen. Sofern im folgenden von "Polygon-Verbindungen" die Rede ist, sind immer allgemein sämtliche möglichen Unrund-Verbindungen gemeint und umfasst.

Es sind aus dem Stand der Technik zahlreiche und vielgestaltige Verbindungen von Wellen, Achsen und Zapfen mit Naben von Bauteilen, wie zum Beispiel Laufrädern, Zahnrädern, Exzenterscheiben, Hebeln und/oder dergleichen Bauteilen bekannt. Diese lassen sich nach Art der Kraftübertragung unterteilen in formschlüssige Verbindungen, reibschlüssige Verbindungen, vorgespannte formschlüssige Verbindungen und stoffschlüssige Verbindungen. Bei formschlüssigen Verbindungen wird die Verbindung zwischen Welle und Nabe durch eine bestimmte Formgebung, wie zum Beispiel durch ein Keilwellenprofil, eine Kerbverzahnung oder ein Polygonprofil, oder durch zusätzliche, als "Mitnehmer" zu bezeichnende Elemente, wie zum Beispiel Paßfedern, Gleitfedern oder Querstifte hergestellt.

Als formschlüssige Verbindungen sind Polygon-Verbindungen im besonderen zum Übertragung von stoßartigen Drehmomenten geeignet und werden insbesondere für lösbare Verbindungen, Schiebsitze und für Preßpassungen vorgesehen. Polygon-Verbindungen sind im Übrigen selbstzentrierend, das heißt ein eventuell vorhandenes Spiel gleicht sich bei einer Verdrehung symmetrisch aus. Außerdem sind Polygon-Verbindungen hinsichtlich der Kerbwirkung vielfach günstiger als andere Formschlußverbindungen.

EP 1 693 587 A offenbart beispielsweise eine Überlastkupplung, welche zwischen Welle und Nabe eine ein Rutschmoment aufnehmende Buchse enthält. Die Überlastkupplung besteht dabei aus einer Welle und einer Nabe, welche über die Buchse miteinander verbunden sind. Die Buchse ist vorgesehen, um ein Rutschmoment aufnehmen zu können. Dabei ist zwischen Welle und Buchse ein konischer Presssitz vorgesehen, während Buchse und Nabe über mehrere Radialabsätze so miteinander verbunden sind, dass zwischen Nabe und Buchse ein Gleiten der Nabe auf der Buchse bei Überschreitung des vorgegebenen Drehmomentes zulässig ist.

US 2002/198075 A1 offenbart eine Welle-Nabe-Verbindung, welche einen Nabensitz mit einer radialen Stufe, d.h. mit zwei Radialabschnitten, aufweist, wobei die Radialabschnitte mit den jeweiligen Gegenflächen in der Öffnung eines Bauteils mittels einer Presspassung zusammenwirken.

Obgleich sich formschlüssige Welle-Nabe-Verbindungen und hier insbesondere Polygon-Verbindungen im alltäglichen Praxiseinsatz bewährt haben, besteht nach wie vor Verbesserungsbedarf. Der Erfindung liegt deshalb die **Aufgabe** zugrunde, eine gegenüber dem Stand der Technik verbesserte Welle-Nabe-Verbindung der eingangs genannten Art vorzuschlagen, die insbesondere hinsichtlich der Krafteinleitung in die Welle optimiert ist. Darüber hinaus soll die Verbindung hinsichtlich Produktion und/oder der Montage vereinfacht sein.

Zur **Lösung** dieser Aufgabe wird mit der Erfindung vorgeschlagen, dass die Welle-Nabe-Verbindung in Längsrichtung der Welle mehrere Radialabsätze aufweist, die Radialabschnitte bereitstellen, wobei der Nabensitz gegenüber der Nabe des Bauteils ein radiales Übermaß aufweist, wobei das radiale Übermaß mit Bezug auf die einzelnen Radialabschnitte unterschiedlich ausgebildet ist, und wobei die Radialabsätze konische Abstufungsverläufe umfassen.

Die Welle-Nabe-Verbindung soll wenigstens zwei Radialabsätze aufweisen. Damit ist umfasst, dass in einem der beiden Bauteile, das heißt am wellenseitigen Nabensitz oder an der Nabe des Bauteiles wenigstens zwei radiale Stufen ausgebildet ist. Der Nabensitz bzw. die Nabe kann zylindrische und/oder konische Abschnitte aufweisen. Unter "Radialabsatz" bzw. radialer Stufe ist ein konischer ebenso wie ein abgerundeter Abstufungsverlauf umfasst.

Bei aus dem Stand der Technik bekannten Polygon-Verbindungen zwischen Welle und Nabe ist vorgesehen, daß der Nabensitz in Längsrichtung der Welle jeweils in einer Ebene liegende Polygonflächen aufweist. Im Unterschied hierzu wird nun mit der Erfindung vorgeschlagen, dass die Verbindung, also z. B. der Nabensitz wenigstens einen Radialabsatz aufweist, das heißt ein wenigstens zweistufiger Nabensitz vorgesehen ist. Es werden erfindungsgemäß pro Polygonseite also wenigstens zwei Polygonteilflächen zur Verfügung gestellt.

Bevorzugterweise sind in Längsrichtung der Welle mehrere Radialabsätze und damit ein mehrstufiger Nabensitz vorgesehen. Die Anzahl der Radialabsätze bzw. der Nabensitzstufen ergibt sich dabei in Abhängigkeit von der Länge des gesamten Nabensitzes in Längsrichtung der Welle und des Einsatzfalles. Dabei weisen die einzelnen Nabensitzstufen in Längsrichtung der Welle bevorzugterweise die gleiche Länge, das heißt Axialerstreckung auf.

Von besonderem Vorteil der Unterteilung des Nabensitzes in einzelne Stufen durch das Vorsehen einzelner Radialabsätze ist die sich hierdurch ergebende Kraftverteilung der auf die Welle im bestimmungsgemäßen Verwendungsfall einwirkenden Kraft. Die im bestimmungsgemäßen Verwendungsfall auf die Welle infolge einer Belastung der Welle-Nabe-Verbindung einwirkende Maximalkraft wird nämlich aufgrund der Unterteilung des Nabensitzes in einzelne Stufen auf diese verteilt, insbesondere bei Aufbringen von Vorspannungen auf die einzelnen Stufen, wobei die Vorspannungen bevorzugterweise unterschiedlich sind. Dabei entstehen die unterschiedlichen Vorspannungen aufgrund unterschiedlicher Übermaße. Im Ergebnis ergibt sich in vorteilhafter Weise eine Kraftverteilung, die im Unterschied zu einer nur einstufigen Nabensitzausbildung geringere Maximalbeanspruchungen aufweist. Der große Vorteil der erfindungsgemäßen Ausgestaltung liegt also darin, daß sich bei gleichbleibender Gesamtbeanspruchung der Welle ein insgesamt verringerter Beanspruchungsmaximalwert einstellt. Nach dem Stand der Technik besonders belastete Bereiche des Nabensitzes der Welle können so entlastet werden, was zu einer verringerten Maximalbeanspruchung der Welle führt. Unerwünscht hohe Materialspannungen sowohl in der Welle als auch im Nabenbereich können so vermieden werden, was der Grund dafür ist, daß die erfindungsgemäße Welle-Nabe-Verbindung bei gleicher Dimensionierung eine weitaus längere Lebensdauer hat oder eine höhere Gesamtleistung. Bei einer im Vergleich zum Stand der Technik unveränderten Lebensdauer erlaubt die erfindungsgemäße Ausgestaltung eine verminderte Dimensionierung der einzelnen Bauteile, was zu einer Materialeinsparung führt. Insbesondere aber erlangt man durch die erfindungsgemäße Ausbildung mehr Konstruktionsfreiheit und kann je nach Einsatzfall gegenüber dem Stand der Technik erheblich verbesserte Lösungen einsetzen.

Ein weiterer Vorteil gegenüber dem Stand der Technik in Form von zum Beispiel konischen Preßsitzen ergibt sich dadurch, daß für eine bestimmungsgemäße Verwendung eine nicht so hohe Fertigungspräzision erforderlich ist. Insbesondere mit Blick auf eine genaue Lageposition in Längsrichtung der Welle erweist sich dies als vorteilhaft, weil die Leistungsfähigkeit der Verbindung im Unterschied zu vorbekannten konisch-rund-Preßverbindungen nicht mehr durch insbesondere axiale Toleranzen bestimmt wird.

Insgesamt erlaubt die erfindungsgemäße Ausgestaltung eine Verteilung der auf die Welle einwirkenden Maximalkräfte bzw. -spannungen auf mehrere Absätze, so daß insgesamt eine vergleichmäßigte Kraft- bzw. Spannungsverteilung erreicht werden kann. Dies führt in vorteilhafter Weise zu einer Verringerung der Kontaktkorrosion.

Gemäß einem weiteren Merkmal der Erfindung weist der Nabensitz gegenüber der Nabe des Bauteils ein radiales Übermaß auf. Dies kann beispielsweise 10 µm bis 100 µm betragen. Je nach Anwendungsfall kann ein radiales Übermaß von 20 µm bis 80 µm und noch mehr bevorzugt von 25 µm bis 75 µm vorgesehen sein. Die Ausbildung eines solchen radialen Übermaßes bewirkt in Kombination mit der erfindungsgemäßen Ausgestaltung des mehrstufigen Nabensitzes eine nochmal verbesserte Kraft- bzw. Spannungsverteilung. In einer besonderen Ausgestaltung der Erfindung kann dabei vorgesehen sein, daß das radiale Übermaß mit Bezug auf die einzelnen Stufen des Nabensitzes unterschiedlich ausgebildet ist. So kann beispielsweise die erste Stufe des Nabensitzes ein anderes radiales Übermaß als die zweite, dritte oder vierte Stufe des Nabensitzes aufweisen. Die Ausgestaltung eines mit Bezug auf die einzelnen Stufen des Nabensitzes unterschiedlichen Übermaßes schafft in vorteilhafter Weise die konstruktive Möglichkeit, hinsichtlich der Kraft- bzw. Spannungsverteilung auf die einzelnen Stufen des Nabensitzes in vorgebbarer Weise Einfluß zu nehmen. So kann beispielsweise durch eine entsprechend unterschiedliche Ausgestaltung des radialen Übermaßes mit Bezug auf die einzelnen Stufen des Nabensitzes sichergestellt werden, daß die mit Bezug auf die Längserstreckung der Welle endseitigen Stufen des Nabensitzes im bestimmungsgemäßen Belastungsfall weniger stark beansprucht werden, als beispielsweise der oder die mit Bezug auf die Längserstreckung der Welle mittleren Stufen des Nabensitzes.

Die erfindungsgemäß vorgesehene Ausgestaltung gilt für eine Polygon-Verbindung zwischen Welle und Naben im Allgemeinen und ist nicht auf bestimmte Wellenausgestaltungen und/oder Bauteilausgestaltungen beschränkt. Insofern kann die Nabe als separate oder einstückige Komponente des von der Welle aufgenommenen Bauteils ausgebildet sein. Es geht erfindungsgemäß allein um die Ausgestaltung der tatsächlichen Verbindung zwischen der Welle einerseits und der Nabe andererseits. Die Erfindung ist in mehrfacher Hinsicht variabel. Der Arbeitstitel "Polygon-Verbindung" bezeichnet ganz allgemein unrunde Verbindungen, also symmetrische oder asymmetrische Vielecke, Ellipsen, Verzahnungen, Auswerfungen und dergleichen nicht kreisrunde Ausbildungen. Die Bezeichnung "Radialabsatz" bezeichnet wenigstens einen stufenartigen radialen Sprung. Es können unterschiedliche Stufen miteinander kombiniert sein, also zylindrisch, konisch, konisch-konisch, zylindrisch-zylindrisch und dergleichen. Die Übergangsstufen oder Absätze können radial, gerundet, konisch und dergleichen verlaufen. Auch hier sind sämtliche Kombinationen von der Erfindung umfasst.

Darüber hinaus genügt es, wenn an einem der zusammenwirkenden Bauteile zwei Radialabsätzte ausgebildet ist. Die Absätze können je nach Anwendungsfall mit entsprechenden Übermaßen aufeinanderfolgend ausgebildet sein, um so optimale Kraftbedingungen hervorzurufen.

Schlussendlich kann erfindungsgemäß vorgesehen sein, dass aufeinander folgende Polygone um die Längsachse der Welle verlaufend verdreht ausgebildet sind. Im einfachen vorstellbaren Fall eines fünfeckigen Polygons beispielsweise kann eine auf eine erste Polygonstufe folgende zweite Polygonstufe um einen sehr kleinen Winkel verdreht ausgebildet sein. Dies bewirkt weiterhin Verbesserungen hinsichtlich der Kraftübertragung.

Weitere Vorteile und Merkmale der Erfindung ergeben sich aus der nachfolgenden Beschreibung anhand der Fign. Dabei zeigen:
- Fig. 1: in schematischer Darstellung eine Welle-Nabe-Verbindung nach dem Stand der Technik;
- Fig. 1a: mit Bezug auf die Welle-Nabe-Verbindung nach Fig. 1 eine Kraftverteilungskurve;
- Fig. 2: in schematischer Darstellung eine Welle-Nabe-Verbindung nach der Erfindung;
- Fig. 2a: mit Bezug auf die Welle-Nabe-Verbindung nach Fig. 2 eine Kraftverteilungskurve und
- Fig. 3: in schematischer Darstellung die erfindungsgemäße Welle-Nabe-Verbindung in Blickrichtung III nach Fig. 2.

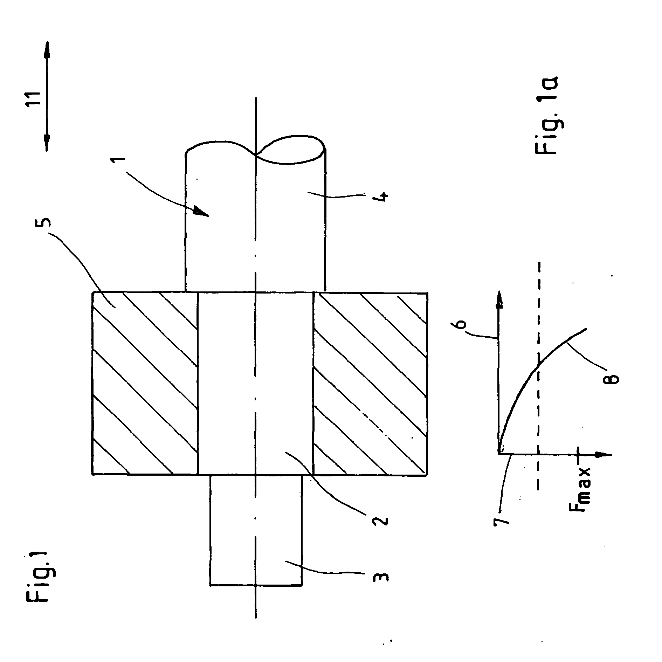

In Fig. 1 ist eine Welle-Nabe-Verbindung mit einem von einer Welle 1 bereitgestellten Nabensitz 2 und einer vom Nabensitz 2 aufgenommenen Nabe eines Bauteils 5 gezeigt. Der Nabensitz 2 und die Nabe des Bauteils 5 bilden eine Polygon-Verbindung aus, das heißt der Nabensitz 2 weist eine im Querschnitt polygonale Außenkontur auf, wobei das Bauteil 5 über eine beispielsweise als Bohrung ausgebildete Aufnahme mit einer zur Außenkontur des Nabensitzes 2 korrespondierend ausgebildete Innenkontur verfügt. Das zum Einsatz kommende Polygonprofil kann beispielsweise ein Fünf-Eck sein. Grundsätzlich gilt natürlich, daß das Polygonprofil als Unrundprofil über bedarfsgemäß entsprechend viele Ecken verfügen kann. Die Erfindung ist insofern nicht auf ein Fünf-Eck Polygonprofil beschränkt.

Wie die Darstellung nach Fig. 1 erkennen läßt, sind der Nabensitz 2 und das davon aufgenommene Bauteil 5 in Längsrichtung 11 der Welle 1 gleich lang bzw. mit Bezug auf die Blattebene nach Fig. 1 gleich breit ausgebildet. Mit Bezug auf die Zeichnungsebene nach Fig. 1 ist der Nabensitz 2 linksseitig wie rechtsseitig jeweils durch einen Anschlußbereich 3 bzw. einen Anschlußbereich 4 begrenzt, welche Anschlußbereiche 3 und 4 im Unterschied zum Nabensitz 2 im Querschnitt kreisförmig ausgebildet sind.

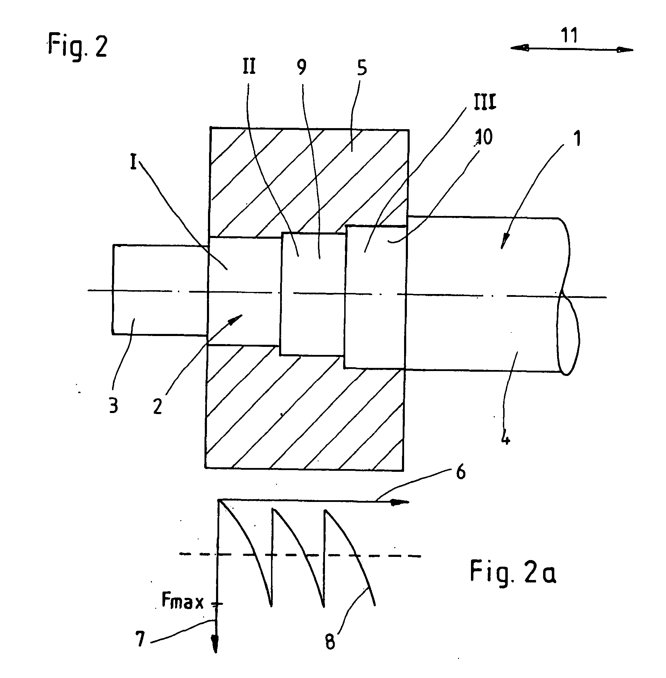

Die in Fig. 1 dargestellte Welle-Nabe-Verbindung ist eine solche nach dem Stand der Technik. Eine erfindungsgemäße Welle-Nabe-Verbindung ist in Fig. 2 gezeigt.

Wie die Darstellung nach Fig. 2 erkennen läßt, verfügt der Nabensitz 2 im gezeigten Ausführungsbeispiel über zwei Radialabsätze 9 und 10, so daß insgesamt ein dreistufiger Nabensitz 2 mit den drei Stufen I, II und III ausgebildet ist. Die Nabe des Bauteils 5 ist zur erfindungsgemäßen Mehrstufigkeit des Nabensitzes 2 entsprechend ausgebildet.

Die einzelnen Stufen I, II und III des Nabensitzes sind mit Bezug auf die Zeichnungsebene nach Fig. 2 gleich breit, das heißt mit Bezug auf die Längsrichtung 11 der Welle 1 gleich lang ausgebildet.

Der die zweite Stufe II des Nabensitzes 2 bildende Radialabsatz 9 überragt die erste Stufe I des Nabensitzes 2 in radialer Richtung je nach Ausführungsform und Anwendungsfall um wenigstens einige µm bis hin zu mehreren Millimetern. In gleicher Weise überragt die durch den Radialabsatz 10 ausgebildete dritte Stufe III die durch den Radialabsatz 9 bereitgestellte zweite Stufe II des Nabensitzes 2 in radialer Richtung.

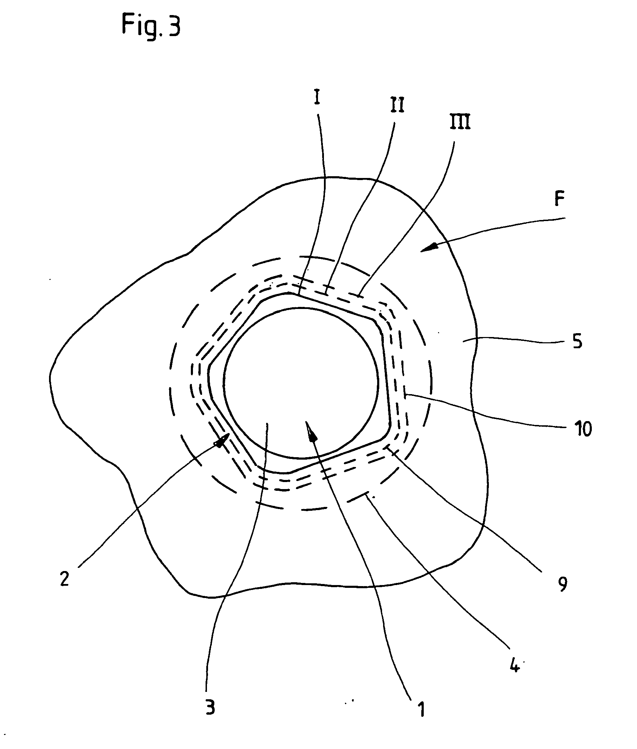

Fig. 3 zeigt die erfindungsgemäße Welle-Nabe-Verbindung in Blickrichtung III nach Fig. 2. Aus dieser Darstellung sind die einzelnen Radialabsätze 9 und 10 bzw. die einzelnen Stufen I, II und III des Nabensitzes gut zu erkennen. Es ist aus dieser Darstellung insbesondere ersichtlich, daß der Nabensitz 2 ein fünf-eckiges Polygonprofil ausbildet, wohingegen die sich an den Nabensitz 2 mit Bezug auf die Darstellung nach Fig. 2 linkswie rechtsseitig anschließenden Anschlußbereiche 3 und 4 im Querschnitt kreisförmig ausgebildet sind.

Wenn im Belastungsfall eine Kraft beispielsweise mit Bezug auf die Zeichnungsebene nach Fig. 2 rechtsseitig des Bauteils 5 auf dasselbe wie in Fig. 3 anhand des Kraftpfeils F gezeigt einwirkt, so ergibt sich eine Beanspruchung der Welle 1 im Bereich des Nabensitzes 2, wie sie beispielhaft in Fig. 2a gezeigt ist. Fig. 2a zeigt ein Diagramm, das die Kraft- bzw. Spannungsverteilung 8 im Bereich des Nabensitzes 2 der Welle 1 zeigt, wobei die in die Welle 1 eingeleitete Kraft auf der y-Achse 7 über die Axialerstreckung des Nabensitzes 2 gemäß x-Achse 6 abgetragen ist. Wie diesem Diagramm entnommen werden kann, ergibt sich ein Kraft- bzw. Spannungsverlauf 8, der mit Bezug auf die Zeichnungsebene nach Fig. 2 je Stufe I, II und III des Nabensitzes 2 von links nach rechts anwächst. Die maximale Beanspruchung ergibt sich jeweils mit Bezug auf die Zeichnungsebene nach Fig. 2 rechtsseitig einer jeden Stufe I, II und III des Nabensitzes 2.

An dieser Stelle sei betont, dass die Figuren 1 a und 2a lediglich der anschaulichen Erläuterung dienen und in keiner Weise wissenschaftlich-technisch korrekt sein sollen.

Die Kraftspitzen definieren darüber hinaus eine durchschnittliche Kraft, die etwa dem Mittelwert zwischen 0 und Fₘₐₓ entspricht. Diese durchschnittliche Kraft ist das Maß für die Leistungsfähigkeit der Welle-Nabe-Verbindung und dieser Mittelwert ist als gestrichelte Linie eingezeichnet.

Bei einer Welle-Nabe-Verbindung nach dem Stand der Technik ergibt sich eine Kraft- bzw. Spannungsverteilung 8, wie sie in Fig. 1 a gezeigt ist. Bei einem Vergleich der Diagramme nach Fig. 1a und Fig. 2a ergibt sich, dass entweder die insgesamt in den Nabensitz 2 eingeleitete Kraft gleich groß ist, daß aber eine Kraftverteilung hinsichtlich der maximal wirkenden Kraft auf die einzelnen Stufen I, II und III des Nabensitzes 2 nach der erfindungsgemäßen Ausgestaltung erreicht ist. Oder andersherum ist die erfindungsgemäße Welle-Nabe-Verbindung höher belastbar und kann eine größere durchschnittliche Kraft übertragen. Damit ergibt sich im Ergebnis, daß bei der erfindungsgemäßen Ausgestaltungsform eine im Vergleich zum Stand der Technik bei gleicher Krafteinleitung minimierte Maximalbelastung auf die Welle 1 einwirkt. Die Minimierung der Maximalbelastung wird dadurch erreicht, daß eine Verteilung der Maximalkräfte und/oder -spannungen auf die einzelnen Stufen I, II und III des Nabensitzes 2 nach der erfindungsgemäßen Ausführungsform stattfindet. Aufgrund dieser Spannungsverteilung kann eine im Vergleich zum Stand der Technik verbesserte, das heißt verringerte Kontaktkorrosion erreicht werden. Oder alternativ kann die erfindungsgemäße Welle-Nabe-Verbindung als deutlich leistungsfähiger angesehen werden, d. h., sie stellt in jeder Hinsicht eine erhebliche Verbesserung dar.

## Patentansprüche

1. Welle-Nabe-Verbindung mit einem von einer Welle (1) bereitgestellten Nabensitz (2) und einer vom Nabensitz (2) aufgenommenen Nabe eines Bauteils (5), wobei der Nabensitz (2) und die Nabe des Bauteils (5) eine Unrund-Verbindung ausbilden, wobei der Nabensitz (2) in Längsrichtung der Welle (1) mehrere Radialabsätze (9, 10) aufweist, die Radialabschnitte (I, II, III) bereitstellen, wobei der Nabensitz (2) gegenüber der Nabe des Bauteils (5) ein radiales Übermaß aufweist, **dadurch gekennzeichnet, dass** das radiale Übermaß mit Bezug auf die einzelnen Radialabschnitte (I, II, III) unterschiedlich ausgebildet ist, und wobei die Radialabsätze (9, 10) konische Abstufungsverläufe umfassen.

2. Welle-Nabe-Verbindung nach Anspruch 1, **dadurch gekennzeichnet, dass** das radiale Übermaß 10 µm bis 100 µm vorzugsweise 20 µm bis 80 µm, mehr bevorzugt 25 µm bis 75 µm beträgt.

3. Welle-Nabe-Verbindung nach einem der vorhergehenden Ansprüche, **dadurch gekennzeichnet, dass** die Nabe als separate und einstückige Komponente des von der Welle (1) aufgenommenen Bauteils (5) ausgebildet ist.

4. Welle-Nabe-Verbindung nach einem der vorhergehenden Ansprüche, **dadurch gekennzeichnet, dass** die Radialabsätze (9, 10) abgerundete Abstufungsverläufe umfassen.

5. Welle-Nabe-Verbindung nach einem der vorhergehenden Ansprüche, **dadurch gekennzeichnet, dass** wenigstens eine der Radialstufen konisch ausgebildet ist.

6. Welle-Nabe-Verbindung nach einem der vorhergehenden Ansprüche, **dadurch gekennzeichnet, dass** aufeinanderfolgende Radialabschnitte gegeneinander verdreht ausgebildet sind.

## Claims

1. A shaft-hub-connection comprising a hub seat (2) provided by a shaft (1) and a hub of a structural component (5) received by the hub seat (2), wherein the hub seat (2) and the hub of the structural component (5) form an out-of-round connection, wherein the hub seat (2) comprises several radial shoulders (9, 10) in the longitudinal direction of the shaft (1), which radial shoulders provide radial sections (I, II, III), wherein the hub seat (2) comprises a radial overmeasure with respect to the hub of the structural component (5), **characterized in that** the radial overmeasure is different with respect to the individual radial sections (I, II, III) and wherein the radial shoulders (9, 10) comprise steps which extend conically.

2. A shaft-hub-connection according to claim 1, **characterized in that** the radial overmeasure is comprised between 10 µm and 100 µm, preferably between 20 µm and 80 µm, more preferably between 25 µm and 75 µm.

3. A shaft-hub-connection according to one of the preceding claims, **characterized in that** the hub is a separate component formed in one piece of the structural component (5) received by the shaft (1).

4. A shaft-hub-connection according to one of the preceding claims, **characterized in that** the radial shoulders (9, 10) comprise steps which extend in a rounded manner.

5. A shaft-hub-connection according to one of the preceding claims, **characterized in that** at least one of the radial steps is conical.

6. A shaft-hub-connection according to one of the preceding claims, **characterized in that** successive radial sections are twisted against each other.

## Revendications

1. Liaison arbre-moyeu comprenant un logement du moyeu (2) fourni par un arbre (1) et un moyeu d'un élément de construction (5) reçu par le logement du moyeu (2), le logement du moyeu (2) et le moyeu de l'élément de construction (5) formant une liaison non ronde, le logement du moyeu (2) comprenant plusieurs épaulements radiaux (9, 10) dans la direction longitudinale de l'arbre (1), lesquels épaulements radiaux fournissent des sections radiales (I, II, III), le logement du moyeu (2) comprenant une surmesure radiale par rapport au moyeu de l'élément de construction (5), **caractérisé en ce que** la surmesure radiale est différente par rapport aux sections radiales individuelles (I, II, III) et les épaulements radiaux (9, 10) comprennent des gradins qui s'étendent de manière conique.

2. Liaison arbre-moyeu selon la revendication 1, **caractérisé en ce que** la surmesure radiale est comprise entre 10 µm et 100 µm, de préférence entre 20 µm et 80 µm, de préférence particulière entre 25 µm et 75 µm.

3. Liaison arbre-moyeu selon l'une des revendications précédentes, **caractérisé en ce que** le moyeu est configuré en tant que composant séparé et d'un seul tenant de l'élément de construction (5) reçu par l'arbre (1).

4. Liaison arbre-moyeu selon l'une des revendications précédentes, **caractérisé en ce que** les épaulements radiaux (9, 10) comprennent des gradins qui s'étendent de manière arrondie.

5. Liaison arbre-moyeu selon l'une des revendications précédentes, **caractérisé en ce qu'**au moins un des gradins radiaux est conique.

6. Liaison arbre-moyeu selon l'une des revendications précédentes, **caractérisé en ce que** des sections radiales successives sont tournées les unes contre les autres.
